Europäisches Patentamt

European Patent Office

Office européen des brevets

(19)

(11) Veröffentlichungsnummer: 0 253 394

A1

# (12) EUROPÄISCHE PATENTANMELDUNG

(21) Anmeldenummer: 87110305.7

(22) Anmeldetag: 16.07.87

(51) Int. Cl.⁴: **C25D 17/24** , H05K 3/00 , H05K 3/18

(30) Priorität: 18.07.86 DE 3624431

(43) Veröffentlichungstag der Anmeldung:
20.01.88 Patentblatt 88/03

(84) Benannte Vertragsstaaten:
AT BE CH DE FR GB IT LI NL SE

(71) Anmelder: **Siemens Aktiengesellschaft Berlin und München**
**Wittelsbacherplatz 2**
**D-8000 München 2(DE)**

(72) Erfinder: **Merkenschlager, Hans-Hermann, Dipl.-Ing.**
**Spielfeldstrasse 15**
**D-8900 Augsburg 21(DE)**
Erfinder: **Szolnoki, Gergely**
**Gladiolenstrasse 11**
**D-8900 Augsburg 21(DE)**
Erfinder: **Zeidler, Wolfgang**
**Ährenstrasse 17**
**D-8900 Augsburg 21(DE)**
Erfinder: **Müiler, Georg, Dipl.-Ing.**
**Blütenstrasse 1**
**D-8901 Rettenbergen(DE)**

(54) **Anordnung zur Stromzuführung an horizontal transportiertes Galvanisiergut.**

(57) Die Erfindung bezieht sich auf eine Anordnung zur Stromzuführung an horizontal transportiertes Galvanisiergut wie z.B. gedruckte Leiterplatten innerhalb des Elektrolyten. Bei derartigen Anordnungen muß sichergestellt werden, daß die stromführende Elektrode nicht metallisiert wird. Das wird durch die Erfindung dadurch gelöst, daß eine unten offene Glocke (5) auf das Galvanisiergut (8) aufgedrückt und durch einen in der Glocke (5) über eine Luftzuführleitung (3) erzeugten Luftüberdruck soweit vom Galvanisiergut (8) abgehoben wird, daß ein Luftpolster (6) zwischen Glocke (5) und Galvanisiergut (8) entsteht. Dadurch ist der Innenraum der Glocke (5) vom Elektrolyten (4) freigehalten, wodurch die Metallisierung der stromführenden Elektrode (2) vermieden wird.

EP 0 253 394 A1

## Anordnung zur Stromzuführung an horizontal transportiertes Galvanisiergut

Die Erfindung betrifft eine Anordnung zur Stromzuführung an horizontal transportiertes Galvanisiergut wie z.B. gedruckte Leiterplatten innerhalb des Elektrolyten.

Bei horizontal transportiertem Galvanisiergut, das innerhalb des Elektrolyten geführt wird, ergibt sich bei direkter Zuführung der stromführenden Elektrode eine Metallisierung derselben.

Aufgabe der vorliegenden Erfindung ist es, eine Anordnung zur Stromzuführung für horizontal transportiertes Galvanisiergut zu schaffen, bei der eine Metallisierung der stromführenden Elektrode nicht auftritt.

Zur Lösung dieser Aufgabe wird gemäß der Erfindung die Anordnung zur Stromzuführung derart ausgebildet, daß eine unten offene Glocke, durch die die stromführende Elektrode geführt ist, auf das Galvanisiergut aufgedrückt und durch einen in der Glocke über eine Luftzufuhrleitung erzeugten Luftüberdruck soweit vom Galvanisiergut abgehoben wird, daß ein Luftpolster zwischen Glocke und Galvanisiergut entsteht.

Durch diese Maßnahmen wird eine unerwünschte Metallisierung der stromführenden Elektrode dadurch vermieden, daß die Kontaktstelle durch ein Luftpolster nach dem Prinzip der Taucherglocke vom Elektrolyten freigehalten wird.

Vorteilhaft ist es dabei auch, unterhalb des Galvanisiergutes eine Gegenplatte vorzusehen, auf die die Glokke bei nicht vorhandenem Galvanisiergut aufgedrückt wird. Dadurch wird auch die Metallabscheidung an der Kontaktstelle dann verhindert, wenn kein Galvanisiergut bearbeitet wird. Prinzipiell könnte die Stromzuführung auch auf der Unterseite der Leiterplatte erfolgen, wobei der Preßluftvorhang zwischen Glocke und Platte die Kupferabscheidung an der Kontaktierschwelle behindert.

Der Druck von oben auf die Glocke kann beispielsweise von einer Feder erzeugt werden.

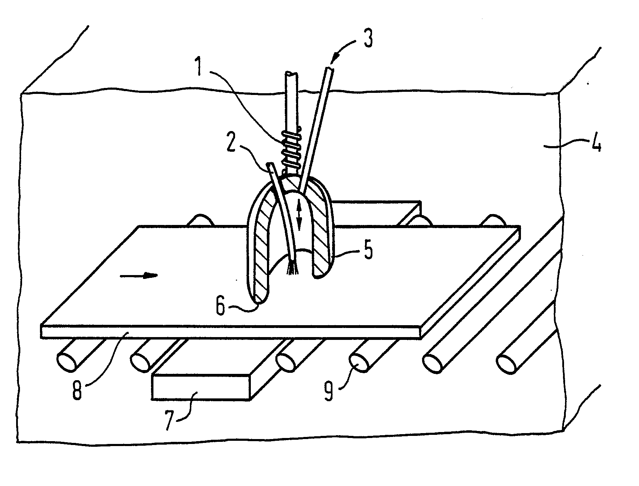

Anhand des Ausführungsbeispiels nach der Figur wird die Erfindung näher erläutert. Innerhalb des Elektrolyten 4 befindet sich eine Transportanlage mit den Führungsrollen 9, auf der als Galvanisiergut 8 eine gedruckte Leiterplatte von links nach rechts horizontal bewegt wird. Eine Glocke 5 ist über eine Feder 1 auf das Galvanisiergut 8 aufgedrückt, wobei über den Luftanschluß 3 Überdruck in der Glocke 5 erzeugt wird, wodurch sich die Glocke leicht gegen die Feder 1 anhebt, so daß zwischen dem Galvanisiergut 8 und der Glocke 5 ein Luftpolster entsteht. Der Innenraum der Glocke 5 ist dadurch vom Elektrolyten 4 freigehalten. Die stromführende Elektrode 2 wird in das Innere der Glocke 5 geführt, und da in ihrer Umgebung sich keinerlei Elektrolyt mehr befindet, kann eine Metallisierung der stromführenden Elektrode 2 nicht auftreten. Die Glocke 5 ist an ihrem unteren offenen Ende gerundet, so daß das Galvanisiergut 8 leichter unter der Glocke 5 hindurchgeführt werden kann. Unterhalb des Galvanisiergutes 8 ist dabei eine Gegenplatte 7 angeordnet, auf die die Glocke 5 dann aufgesetzt wird, wenn sich kein Galvanisiergut 8 auf der Transportanlage befindet, wodurch auch in diesem Fall die Metallisierung der stromführenden Elektrode 2 vermieden wird.

## Ansprüche

1. Anordnung zur Stromzuführung an horizontal transportiertes Galvanisiergut wie z.B. gedruckte Leiterplatten innerhalb des Elektrolyten, **dadurch gekennzeichnet,** daß eine unten offene Glocke (5), durch die die stromführende Elektrode (2) geführt ist, auf das Galvanisiergut (8) aufgedrückt und durch einen in der Glocke (5) über eine Luftzufuhrleitung (3) erzeugten Luftüberdruck soweit vom Galvanisiergut (8) abgehoben wird, daß ein Luftpolster (6) zwischen Glocke (5) und Galvanisiergut (8) entsteht.

2. Anordnung zur Stromzuführung an horizontal transportiertes Galvanisiergut nach Anspruch 1, **dadurch gekennzeichnet,** daß unterhalb des Galvanisiergutes (8) eine Gegenplatte (7) vorgesehen ist, auf die die Glocke (5) bei nicht vorhandenem Galvanisiergut (8) aufgedrückt wird.

3. Anordnung zur Stromzuführung an horizontal transportiertes Galvanisiergut nach einem der vorhergehenden Ansprüche, **dadurch gekennzeichnet,** daß der Druck von oben auf die Glocke (5) mittels einer Feder (1) erzeugt wird.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. 4) |
|---|---|---|---|
| A | DE - A1 - 3 447 598 (GUSTAV ERHARDT ELOXALWERK U. TEILEFERTI-GUNG) <br> * Ansprüche * <br> -- | 1 | C 25 D 17/24 <br><br> H 05 K 3/00 <br><br> H 05 K 3/18 |
| A | US - A - 4 421 623 (F.KOCH et al.) <br> * Fig.; Ansprüche * <br> ---- | 1 | |

**RECHERCHIERTE SACHGEBIETE (Int. Cl. 4)**

C 25 D

H 05 K

Der vorliegende Recherchenbericht wurde für alle Patentansprüche erstellt.

| Recherchenort | Abschlußdatum der Recherche | Prüfer |
|---|---|---|
| WIEN | 13-10-1987 | SLAMA |